# EUROPÄISCHE PATENTSCHRIFT

(11) **EP 0 478 908 B1**
(45) Veröffentlichungstag und Bekanntmachung des Hinweises auf die Patenterteilung: **25.01.1995**
(21) Anmeldenummer: 91112187.9
(22) Anmeldetag: 20.07.1991
(51) Int. Cl.: C23C 16/50, C23C 16/44

(54) **Verfahren und Anordnung zur gleichspannungs-bogenentladungsunterstützten, reaktiven Behandlung von Gut**
Process and apparatus for reactively treating objects by means of a glow discharge
Procédé et appareillage pour le traitement réactif d'objets au moyen d'une décharge, luminescente en courant continu

(30) Priorität: 14.09.1990 DE 4029268
(43) Veröffentlichungstag der Anmeldung: 08.04.1992
(73) Patentinhaber: BALZERS AKTIENGESELLSCHAFT, 9496 Balzers (LI)
(72) Erfinder: Karner, Johann, Dr., A-6800 Feldkirch (AT); Bergmann, Erich, Dr., CH-8887 Mels (CH)
(74) Vertreter: Troesch Scheidegger Werner AG

(56) Entgegenhaltungen:
- EP-A- 0 115 970
- GB-A- 2 176 808
- GB-A- 2 178 228
- US-A- 4 731 255
- PATENT ABSTRACTS OF JAPAN, vol. 9, no. 271 (C-311)(1994), 29. Oktober 1985; & JP-A-60 118 693

## Beschreibung

Die vorliegende Erfindung betrifft Verfahren nach dem Oberbegriff von Anspruch 1 sowie eine Anlage nach dem Oberbegriff von Anspruch 19.

Ein Verfahren der genannten Art bzw. eine solche Anlage sind aus der CH-A-664 768 bekannt. Aus der US-A-4 851 254 ist ein Verfahren zur reaktiven, plasmaunterstützten Beschichtung von Gut bekannt, bei welchem in einem Vakuumrezipienten zwischen zwei sich unmittelbar benachbarten Elektroden eine Gleichspannungsbogenentladung unterhalten wird, mit tiefer Spannung unter 100V und relativ hohen Bogenströmen in der Grössenordnung zwischen 50A und 100A.

Das zu beschichtende Gut wird ausserhalb der Kathoden/Anodenstrecke parallel zur Bogenentladung isoliert angebracht. Ein Arbeitsgas, welches mindestens teilweise reagiert, wird durch eine Rohrleitung, dem zu behandelnden Gut bezüglich Anoden/Kathodenstrecke entgegengesetzt liegend, dem Plasma zugedüst.

Bei plasmachemischen Verfahren ist der Reaktionsraum im wesentlichen auf eine Umgebung der Plasmazone beschränkt, deren Ausdehnung von der Grössenordnung der freien Weglänge ist. Diese ist wiederum dem Kehrwert des Druckes proportional. Ein Absenken des Druckes zur Ausdehnung des Reaktionsraumes ist aber im allgemeinen nicht möglich, da damit ja auch die Konzentration der Reaktanden sinkt.

Daher ist dieses Vorgehen dahingehend nachteilig, als dass nur kleine Oberflächen beschichtet werden können, aufgrund des kleinen Oberflächenbereiches, welches der kurzen Anoden/Kathodenstrecke benachbart liegt, und aufgrund des punktuellen Eindüsens des reaktiven Arbeitsgases.

Aus der US-A-4 859 490 ist ein weiteres Vorgehen zum reaktiven, plasmaunterstützten Beschichten von Gut bekannt. Dabei wird in einem Rezipienten, freiliegend, eine Glühkathodenwendel vorgesehen, ein diesbezüglich auf positives anodisches Potential gelegtes Gitter und, bezüglich der Glühwendel dem Gitter entgegengesetzt gelegen, eine bezüglich Gitter kathodisch geschaltete Elektrode, worauf das zu behandelnde Gut abgelegt ist.

Gas, welches im wesentlichen in dem zwischen Glühwendel und Gitter gebildeten Plasma zur Reaktion gebracht wird, wird zentral in den Rezipienten und gegen die Glühwendel eingedüst. Nachteilig daran ist, dass das reaktive Gas vorerst die Glühwendel durchstreichen muss und mit der Glühwendel reagiert. Dadurch kann einerseits der Beschichtungsprozess des Gutes durch die Wendel gestört werden, und die Standzeit der Glühwendel wird drastisch reduziert.

Als Beispiel möge die Abscheidung von Diamantschichten aus Kohlenwasserstoff/Wasserstoffgemischen dienen. Die Karburierung der Filamente aus Refraktärmetall geht dabei für derartige Anordnungen so rasch vor sich, dass diese nach 1 bis 3 Beschichtungszyklen durch Bruch ausfallen. Dies ist vom Standpunkt einer kontrollierten Fertigung unakzeptabel. In anderen Gasen ergeben sich ähnliche Probleme als Verzunderung bzw. Hydrid- oder Silizidbildung.

Die Nachteile dieser letztgenannten beiden Schriften werden durch das Vorgehen nach der eingangs genannten Schrift behoben, indem es daraus bekannt ist, zwischen einer Anode und einer Kathode eine Niederspannungs-Gleichspannungs-Bogenentladung zu erzeugen, indem in diese Strecke geladene Teilchen, Elektronen und Ionen eingelassen werden, womit es möglich wird, zwischen Anoden und Kathoden bei tiefen Bogenspannungen einen Bogen zu unterhalten, welche Elektroden wesentlich weiter auseinanderliegen als gemäss der US-A-4 851 254.

Dadurch, dass, auch im Unterschied zu US-A-4 859 490, z.B. die thermisch emittierten Elektronen nicht im Rezipienten, sondern ausserhalb des Rezipienten erzeugt werden und durch eine Oeffnungsanordnung in letzteren eingekoppelt werden, wird auch die Behandlungskontamination durch das Material der Heisswendel bzw. deren Standzeitreduktion durch den Behandlungsprozess behoben.

Aus der GB-A-2 178 228 ist es weiter bekannt, die Temperatur von gleichspannungs-bogenentladungs-unterstützt beschichteten Werkstücken durch Steuerung des von ihnen abfliessenden Stromes zu beeinflussen.

Nachteilig an dem Vorgehen gemäss der CH-A-664 768 ist nun einerseits, dass im Behandlungsrezipienten in dessen Randbereich eine linienförmige Ausdüsung von Arbeitsgas mit zur Reaktion zu bringendem reaktivem Gas vorgenommen wird bzw. dass im Innenraum des Rezipienten, über dessen Volumen betrachtet, eine inhomogene Entladung bzw. Plasmaverteilung eintritt.

Dies ist bei vielen Verfahren so störend, dass es ihre Ausführung verhindert. Jede plasmachemische Reaktion benötigt eine gewisse Plasmadichte, das heisst eine minimale Raumdichte von Ladungsträgern dort, wo sie ablaufen soll. Diese nimmt in der Anordnung von CH-664 768 radial rasch ab. Eine Erhöhung der Bogenleistung löst dieses Problem nicht immer. Die Erwärmung der Substrate im Bogenplasma wird vor allem aus der Strahlung gespeist. Deren radiale Ausdehnung ist ungehindert. Das bewirkt, dass bei einer Erhöhung der Leistung die thermische Belastung der Substrate wesentlich stärker zunimmt als die für die Abscheidung notwendige Plasmadichte.

Die vorliegende Erfindung setzt sich nun zum Ziel, ausgehend von der letzterwähnten, vorteilhaften Bogenerzeugung, die genannten Nachteile zu beheben.

Hierzu zeichnet sich das erfindungsgemässe Verfahren der obgenannten Art nach dem kennzeichnenden Teil von Anspruch 1 aus.

Ebenso zeichnet sich eine erfindungsgemässe Anlage nach dem kennzeichnenden Teil von Anspruch 19 aus.

Bevorzugte Ausführungsvarianten sowohl der genannten Verfahren wie auch der genannten Anlagen sind einerseits in den abhängigen Ansprüchen 2 bis 18 definiert bzw. 19 bis 35 und gehen aus der nachfolgenden Erfindungsbeschreibung hervor.

Insbesondere muss darauf hingewiesen werden, dass durch Erzeugen einer räumlich verteilten Niederspannungsbogenentladung mit rezipient-extern erzeugten geladenen Teilchen und deren Einkopplung in die Anoden/Kathodenstrecke des Rezipienten ermöglicht wird, weiträumige Plasmen hoher Ionisationsdichte und akzeptabler Energiedichte zu realisieren, wie beispielsweise mit Bogenspannungen < 150V Bogen über Strecken grösser als 30cm. Dies bei Stromdichten von einigen 100A pro m2 Anoden/Kathodenflächen bis über einige kA pro m2. Dabei werden Temperaturen im Plasma unter 900°, wie von 800° und weniger, realisiert, was insbesondere auch gekoppelt mit einem verteilten Einlass von Arbeitsgas in den Rezipienten die Behandlung grosser Oberflächenbereiche von Gütern oder vieler Einzelgüter ermöglicht. Dank der relativ tiefen Temperaturen und der hohen Energiedichten sind Behandlungsprozesse an thermisch empfindlichen Gütern durchführbar, die bislang nur schwer möglich waren bzw. nur mit exzessiver Kühlung des zu behandelnden Gutes.

Die Erfindung wird anschliessend beispielsweise anhand von Figuren erläutert.

Es zeigen:
- Fig. 1: schematisch eine erste Ausführungsvariante einer erfindungsgemässen Anordnung bzw. daran, eine erste Variante des erfindungsgemässen Verfahrens,
- Fig. 1a: ein Temperatursteuerverfahren anhand einer Halterung für zu behandelndes Gut, wie in Fig. 1 vorgesehen, gezeigt,
- Fig. 1b: schematisch eine Teil-Schnittdarstellung einer an der Anordnung gemäss Fig. 1 in einer Alternativen eingesetzten Funkenkammer,
- Fig. 2: eine zweite erfindungsgemässe Anordnung bzw. daran ein zweites erfindungsgemässes Vorgehen, schematisch dargestellt,
- Fig. 3: schematisch eine für sich erfinderische Kombination der Vorgehensweisen nach den Fig. 1 und 2, gezeigt an einer schematischen Blockdarstellung,
- Fig. 4: schematisch einen Längsschnitt durch eine bevorzugte erfindungsgemässe Anordnung, dem Vorgehen nach Fig. 3 folgend,
- Fig. 5: eine detailliertere Ausführungsvariante im Längsschnitt der Anordnung nach Fig. 4, wie sie derzeit bevorzugt eingesetzt wird,
- Fig. 6: schematisch eine weitere Ausführungsvariante einer erfindungsgemässen Anlage, dem Prinzip nach Fig. 3 folgend und zum Teil mit der Ausführung gemäss den Fig. 4 und 5 übereinstimmend,
- Fig. 7: schematisch die an einer erfindungsgemässen Anordnung elektrisch betriebenen Aggregate und deren erfindungsgemässe Einstell- bzw. Steuerungsvarianten anhand eines Funktionsblockdiagrammes.

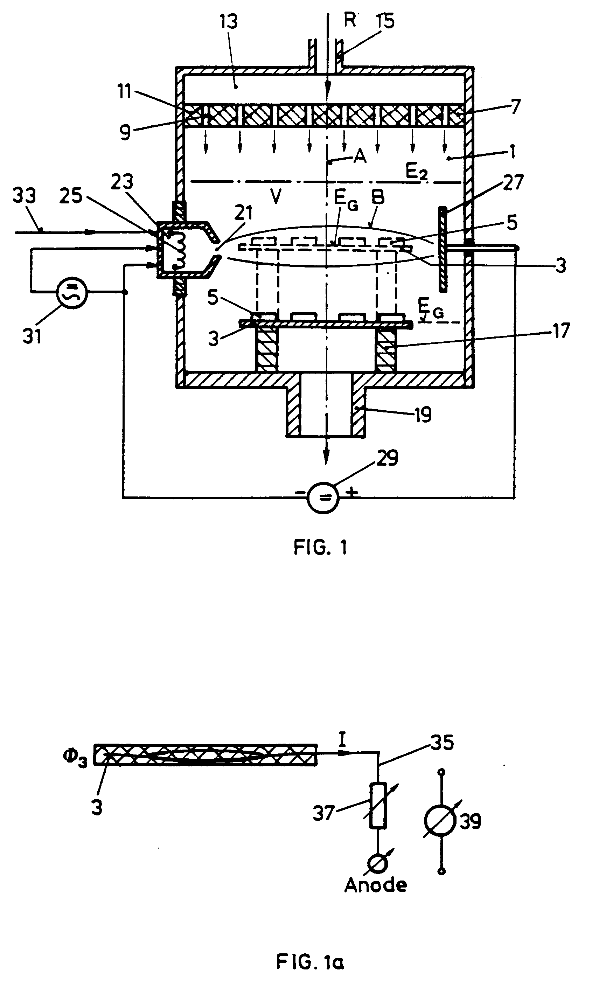

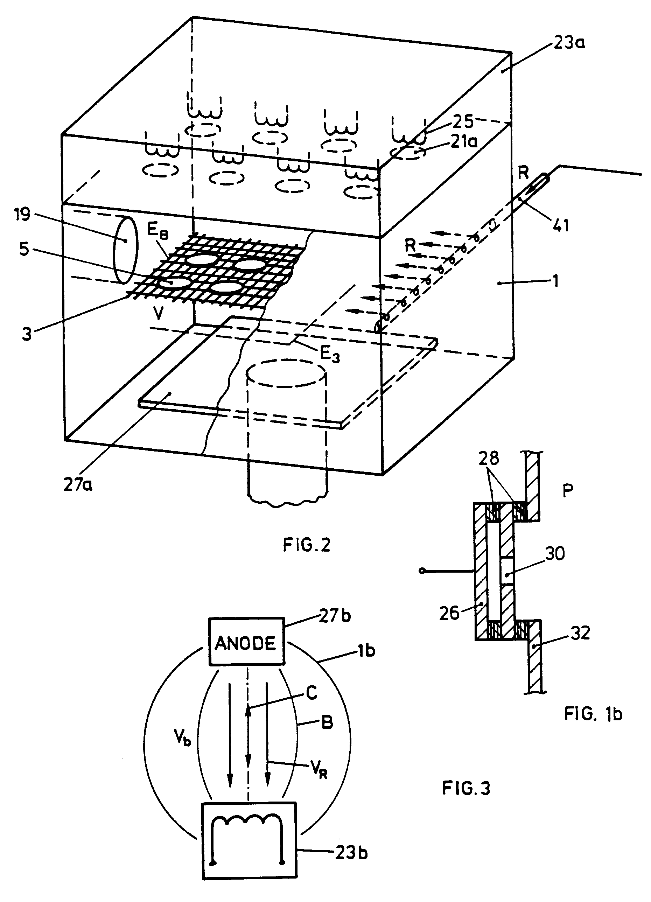

In Fig. 1 ist schematisch eine erste Ausführungsvariante einer erfindungsgemässen Behandlungskammer dargestellt zur Erläuterung einer ersten Ausführungsvariante des erfindungsgemässen Vorgehens.

In einem Vakuumbehandlungsrezipienten 1 ist auf einer Halterung 3 das zu behandelnde Gut 5 in Form eines oder, wie dargestellt, mehrerer Werkstücke abgelegt. Die Halterung 3 definiert für das zu behandelnde Gut eine Ablagefläche, hier eine Ablageebene E_{G}. Der Halterung 3, und mithin der Fläche E_{G} gegenüberliegend, ist am Rezipienten 1 eine Einlassanordnung 7 vorgesehen für ein Arbeitsgas bzw. -gasgemisch R mit Reaktionsgas bzw. -gasgemisch.

Die Einlassanordnung 7 umfasst eine flächig verteilte Anordnung von Einlassöffnungen 9 in einer Platte 11, welche aus einer Druckausgleichskammer 13 gespiesen werden, die, bezüglich der Platte 11 vom Reaktionsraum V des Rezipienten 1 abgewandt, selbst durch eine oder mehrere Zuführleitungen 15 gasgespiesen ist.

Im dargestellten Ausführungsbeispiel ist die Halterung 3 tischartig ausgebildet und an der Rezipientenwandung mittels Isolationen 17 abgestützt. Unterhalb der Halterung 3 ist eine Absaugleitung 19 zur Evakuierung des Rezipienten 1 sowie, während des Behandlungsprozesses, zum Absaugen gasförmiger Reaktionsprodukte bzw. von verbrauchten Arbeitsgas vorgesehen.

Durch eine Blendenöffnung 21 mit dem Reaktionsraum V des Rezipienten 1 kommunizierend, ist eine Heisskathodenkammer 23 vorgesehen, worin eine direkt oder indirekt beheizte Heisskathode 25 angeordnet ist. Der Blendenöffnung 21 gegenüberliegend ist im Rezipienten 1 eine Anode 27 vorgesehen.

Wie schematisch dargestellt, wird zwischen Heisskathode 25 und Anode 27 eine zur Unterhaltung einer Bogenentladung B notwendige Gleichspannung angelegt, mittels eines Gleichspannungsgenerators 29. Die Beheizung der Heisskathode 25 erfolgt, bei elektrischer Beheizung, mittels eines Generators 31. Bei diesem Generator kann es sich um einen Gleich- oder Wechselstromgenerator, gegebenenfalls mit nachgeschalteten Trenntransformator, handeln.

Im Prinzip eignet sich jede Ausführungsform für die Kathode der Bogenentladung, sofern sie geeignet ist, einen genügend hohen Strom unter stabilen Betriebsbedingungen zu liefern. Insbesondere kann die Ionisationskammer 23 durch eine Hohlkathode ersetzt werden.

In einer wiederum anderen Ausführungsform wird die Ionisationskammer als Funkenkammer ausgebildet. Diese ist in Fig. 1b schematisch dargestellt. Einzelheiten der Ausführung einer solchen Baugruppe sind aus der Aufdampftechnik, wo sie bereits Verwendung findet, bekannt, zum Beispiel aus DE-OS 34 13 701. Fig. 1b zeigt schematisch eine solche Funkenkammer mit wassergekühlter Kathode 26, Isolation 28, Blende 30 und Kammerwand 32. Die Anode ist in der Kammer angeordnet.

Die Blende 30 bzw. 21, die die Kathodenkammer wie die Funkenkammer vom Beschichtungsraum P trennt, muss so ausgeführt sein, dass einerseits kein Metalldampf aus der Kammer in die Beschichtungskammer austritt, anderseits die Elektronen den Weg zur Anode in der Beschichtungskammer finden.

Das Volumen der Druckausgleichskammer 13 ist so gross, dass sich darin bezüglich der Einlassöffnungen 9 eine gleichförmige Druckverteilung des durch die Leitung 15 zugeführten Gases ergibt, und durch Verteilung der Einlassöffnungen, deren Strömungsquerschnitte sowie ihre axiale Länge, mithin über ihre Strömungswiderstände und ihre Mündungsrichtung, wird gezielt eine erwünschte, im wesentlichen gerichtete Einströmungsverteilung des Gases in den Rezipienten 1 bewirkt.

Im dargestellten Beispiel wird durch Gleichverteilung und Gleichausbildung der Oeffnungen 9 an der Platte 11 eine im wesentlichen gleichförmige, gegen die Halterung 3 gerichtete Gasausströmung erzielt. Das in den Reaktionsraum V eingelassene Arbeitsgas reagiert teilweise darin zu einem in der Zeit zunehmenden Anteil, und verbrauchtes Arbeitsgas wird durch Leitung 19 abgesaugt.

Durch den verteilten Arbeitsgaseinlass und die im wesentlichen zu diesem Einlass zentrale Absaugung 19 ergeben sich im Reaktionsraum V entlang strichpunktiert eingetragener Flächen E₂ je im wesentlichen gleiche Verhältnisse unverbrauchten Arbeitsgases zu verbrauchten Arbeitsgas. Dadurch, dass durch die Halterung 3 das zu behandelnde Gut auf einer solchen Fläche positioniert wird, wird eine gleichförmige Behandlungswirkungsverteilung mindestens auf zu dieser Fläche aequidistanten Oberflächenbereichen des Gutes erzielt.

Durch die erwähnte Ausrichtung und Ausbildung der Einlassöffnungen 9 wird, zusammen mit der Anordnung der Absaugung, die Form der erwähnten Aequi-Verteilungsflächen E₂ wesentlich mitbestimmt, welche im dargestellten Beispiel zueinander parallele Ebenen sind. Da im hier dargestellten Beispiel nur in einem kleinen Volumenbereich eine Bogenentladung B unterhalten wird, ist deren Wirkung nicht im ganzen Reaktionsraum V gleich.

Nun gibt es Beschichtungsaufgaben, wo diese ungleiche Plasmaverteilung der Bogenentladung B durch gezielten ungleichen Gaseinlass kompensiert werden kann oder wo sie keine Rolle spielt, da man sowieso mit einem starken Ueberschuss von Reaktandengas arbeitet. In diesem Fall gilt es, nur die ungleiche Schichtverteilung auszugleichen, was zum Beispiel bei kleinen Gütern mit einem Drehkorb mit Planetenspindeln gemacht werden kann.

Der Rezipient 1 wird vorzugsweise allseits aus einem den Behandlungsprozess nicht beeinträchtigenden Material gebildet, üblicherweise aus rostfreiem Stahl. In spezifischen Fällen kann die Wand des Rezipienten 1 auch aus Quarzglas oder einen keramischen Material bestehen.

Die Halterung 3 und mithin das Gut werden in einer Variante nicht auf ein bestimmtes elektrisches Potential gelegt, sondern, wie mit den isolierenden Stützen 17 dargestellt, potentialfliegend betrieben, so dass sich daran ein elektrisches Potential einstellen kann gemäss der Potentialverteilung im Reaktionsraum V. Dadurch wird die Behandlungstemperatur des Gutes abgesenkt, gegenüber den Fall, in dem das Gut auf Anodenpotential gehalten wurde.

Auf diese Art und Weise ist in einem ersten Schritt bereits eine gezielte Behandlung von grossflächigem Gut möglich, durch ein reaktives, bogenplasma-unterstütztes Verfahren. Bei der auf gezeigte Art erzeugten Bogenentladung handelt es sich um eine lange Niederspannungsentladung, die bei Drücken nur einiger Pa mit einer tiefen Gleichspannung, z.B. unterhalb 150V, üblicherweise bei Spannungen von der Grössenordnung der Ionisierungsenergie des Arbeitsgasgemisches, unterhalten wird.

Um zu verhindern, dass im Reaktionsraum gezielt zur Reaktion gebrachte Gase mit der Heisskathode 25 in Kontakt treten, deren Material dann den Behandlungsprozess beeinflussen und mitreagieren würde, womit ihre Lebensdauer auch drastisch verringert würde, wird in der Kathodenkammer 23 bevorzugterweise, z.B. durch eine Leitung 33, ein Spülgas eingelassen. Dabei kann der Druck in der Kathodenkammer 23 so eingestellt werden, dass er geringfügig höher ist als der Arbeitsdruck in Reaktionsraum V, womit eine Gasausströmung aus Kammer 23 erzielt wird.

Beim Betrieb von Niederspannungsentladungen mit Heisskathoden ist es wesentlich, dass ein neutraler Plasmastrom von der Ionisationskammer in die Beschichtungskammer austritt, also eine gleiche Anzahl Ionen wie Elektronen. Als Spülgas wird auf jeden Fall ein prozesskompatibles Gas eingeführt, üblicherweise Edelgase.

Mit den so erzeugten Niederspannungsbogen kann ein Plasma mit relativ niedriger Gastemperatur - bei hoher Elektronentemperatur - in der Grössenordnung von 200°C bis 1000°C erzeugt werden. Dies erlaubt es, das Gut zwischen Kathode und Anode anzuordnen, wie gestrichelt dargestellt, was für Behandlungsprozesse, die eine hohe Plasmadichte bei tiefen Guttemperaturen erfordern, ausserordentlich vorteilhaft ist.

In Fig. 1a ist ausschnittsweise die Halterung 3 von Fig. 1 dargestellt. Wie erwähnt wurde, stellt sich aufgrund der potentialfliegenden Montage der Halterung 3 daran ein entsprechend der Potentialverteilung im Reaktionsraum V herrschendes, elektrisches Potential Φ₃ ein. Nun wird in einer Weiterentwicklung der in Fig. 1 dargestellten Anordnung die Halterung 3 vorzugsweise durch einen Stromzweig 35, über ein Widerstandselement 37, mit einem Bezugspotential, beispielsweise Anodenpotential, verbunden. Damit stellt sich nach Massgabe der Impedanzverhältnisse im Reaktionsraum V und dem Wert des Widerstandselementes 37 über letzteren eine Potentialdifferenz ein, und der dadurch getriebene Strom I wird als Temperatursteuergrösse für die Temperatur der Halterung und mithin des Gutes eingesetzt.

Alternativ dazu kann das Potential des Gutes, entkoppelt vom Bogenstrom, durch eine verstellbare Spannungsquelle 39 zwischen Anoden- und Kathodenpotential im Raum V verstellt werden. Diese Vorgehen eignen sich insbesondere für die Feineinstellung oder die Regelung der Guttemperatur. Zum Stellen des "Heizstrom"-Wertes I wird der Widerstandswert um einen Arbeitspunkt herum verstellt.

Auch durch Verstellen des Gutpotentials, entkoppelt von der Entladung, wird die Guttemperatur verstellt.

Für einige Prozesse ist es auch vorteilhaft, die wachsende Schicht mit Elektronen zu beschiessen. Die Steuerung oder Regelung des aufgebrachten Elektronenstroms erfolgt analog: Der abfliessende Strom I ist ein Mass für den Elektronenstrom; er kann durch Widerstand bzw. direkte Potentialverschiebung am Substrat beeinflusst werden.

Zur Temperaturregelung wird, wie den Fachmann nun ohne weiteres klar, die Temperatur der Halterung 3 abgegriffen, ein ihr entsprechendes elektrisches Signal mit einem Sollwert verglichen, und Widerstandswert des Widerstandselementes 37 und/oder Spannungswert an der Spannungsquelle 39 je als Stellglieder regelnd gestellt.

Durch Variation des Sollwertes während des Behandlungsprozesses kann die Guttemperatur in Sinne einer Führungsregelung einer vorgegebenen Zeitcharakteristik nachgeführt werden.

Ausgehend von der Anordnung nach Fig. 1 ergeben sich nun folgende Weiterentwicklungsschritte:
- anstelle oder zusätzlich zum gezielt verteilten Arbeitsgaseinlass, das Erzeugen einer gezielt verteilten, langen Niederspannungs-Bogenentladung,
- eine wesentliche Erhöhung der Ausnützung des Volumens des Reaktionsraumes V durch Anordnen von zu behandelnden Gut auf mehreren Verteilungsflächen E₂.

Die Absaugung 19 braucht nicht zentral vorgenommen zu werden, sondern kann auch peripher und/oder verteilt erfolgen.

In Fig. 2 ist, wiederum anhand einer schematisch dargestellten erfindungsgemässen Anordnung, eine weitere erfindungsgemässe Lösung dargestellt. Hier wird nicht der Gaseinlass gezielt verteilt ausgebildet, sondern die Bogenentladung.

In Fig. 2 dargestellte Komponenten, die bereits bei der Ausführungsvariante gemäss Fig. 1 erläutert wurden, sind mit den gleichen Positionsnummern versehen.

Am Behandlungsrezipienten 1, hier kubisch ausgebildet, welchem über eine endständig gelochte Zuführleitung 41, in diesem Falle nicht flächig verteilt, das Arbeitsgas R zugeführt wird, ist eine Heisskathodenkammeranordnung 23a vorgesehen, welche sich entlang einer Quaderwand des Rezipienten 1 erstreckt. Darin sind, flächig verteilt wirkend, ein oder mehrere Heisskathoden 25 vorgesehen.

Die Kathodenkammeranordnung 23a, bei der es sich selbstverständlich auch um einzelne getrennte Kammern, entsprechend verteilt, handeln kann, ist über mehrere Blendenöffnungen 21a mit den Reaktionsraum V des Rezipienten 1 verbunden. Im Rezipienten ist den Blenden 21a gegenüberliegend die rechteckige oder quadratförmige Anode 27a angeordnet. Quer zur Entladungsrichtung ist ein Halterungsgitter 3 für zu beschichtende Güter 5 vorgesehen, die Absaugung 19 auf der der Arbeitsgaszuführung 41 zugewandten Quaderseite. Die mehreren Bogenentladungen, hier flächig verteilt, ergeben entlang Flächen E_{B} eine für einige Anwendungen ausreichend gleichförmige Beschichtung, trotz der nicht flächig verteilten Arbeitsgaszuführung. Auch hier kann die Gleichförmigkeit der Beschichtung durch gezielte Verteilung der Entladungen beeinflusst werden. Mit E₃ sind Flächen eingetragen, entlang welchen die Plasmadichte im wesentlichen konstant ist, bei gleich verteilten und gleich betriebenen Anoden/Kathodenstrecken.

Durch gezielte flächige oder räumliche Verteilung und/oder Ansteuerung jeweils einzelner oder gruppierter Anoden/Kathodenstrecken wird im Reaktionsraum V die räumliche Plasmaverteilung beeinflusst. Somit kann bei reaktiven Behandlungsprozessen bzw. Kammern hierfür mit den erläuterten langen Niederspannungsbogenentladungen die räumliche Wirkungsverteilung entweder durch gezielt grossflächige Verteilung des Arbeitsgaseinlasses oder durch gezielte räumliche Verteilung der Bogenentladungen eingestellt werden, so dass, mit gewollter Behandlungsverteilung, grossflächige Güter oder gleichzeitig viele behandelt werden können, dies auch dreidimensional. Die Bogenentladungen können auf mittels Funkenkammern der im Zusammenhang mit Fig. 1b gezeigten Art verteilt erzeugt werden.

Ohne weiteres ersichtlich wird nun, dass die beiden erfinderischen Massnahmen gemäss Fig. 1 und Fig. 2 bevorzugterweise kombiniert werden, indem sowohl der Gaseinlass mit gezielt flächiger Verteilung vorgenommen wird wie auch die Bogenentladungen räumlich gezielt verteilt erzeugt werden. Eine solche Anordnung wird anschliessend anhand eines bevorzugten Spezialfalles beschrieben, wobei der Fachmann bereits aus kombinierter Betrachtung der Fig. 1 und 2 grundsätzlich die Kombination der beiden Vorgehen ohne weiteres erkennt.

Es hat sich gezeigt, dass die erwähnte, nach Fig. 1 bzw. 2 erzielte, vorerst zweidimensional gleiche Wirkungsverteilung dann in eine dreidimensionale gleiche Verteilung übergeht, wenn Anoden/Kathodenstrecke und die im wesentlichen durch Ein- und Auslass gegebene Gasverbrauchsrichtung gleich bzw. gegengleich sind.

In Fig. 3 ist diese Vorgehensweise prinzipiell dargestellt, bei der eine Bogenentladung B zwischen einer Heisskathodenanordnung 23b und einer Anodenanordnung 27b in einem wesentlichen Volumenbereich eines Reaktionsraumes V_{b} eines Rezipienten 1b in gleicher Richtung C erfolgt, wie die zwischen Arbeitsgaseinlass und Absaugung festgelegte Verbrauchsrichtung V_{R} des Reaktionsgases. Es werden anschliessend solche bevorzugte Ausführungsbeispiele dargestellt, welche, kombiniert, die Vorgehensweisen nach Fig. 1, 2 und 3 aufzeigen.

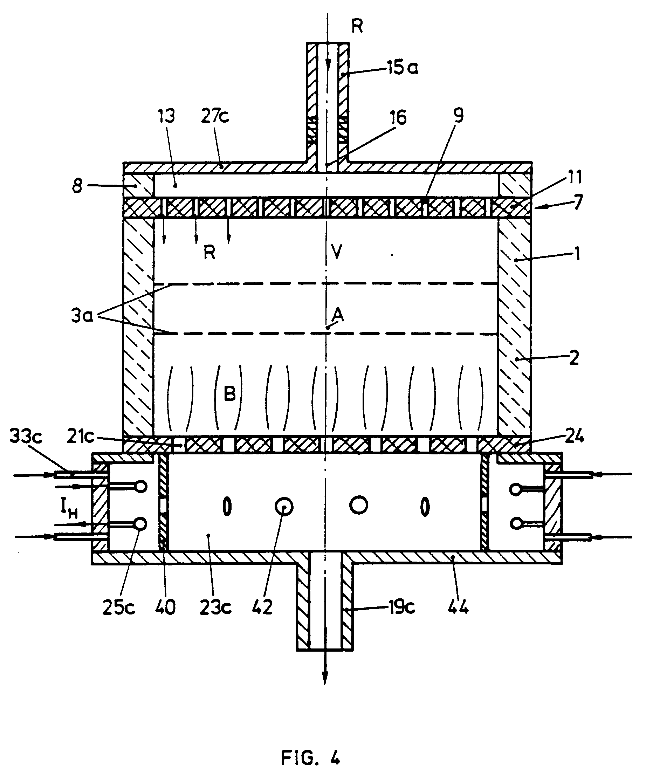

In Fig. 4 ist, schematisch, der grundsätzliche Aufbau einer ersten Ausführungsvariante dargestellt. Der Rezipient 1 weist eine Zylinderwandung 2, beispielsweise aus Quarz, auf. Abgeschlossen wird der von der Wandung 2 begrenzte Reaktionsraum V einerseits durch die Einlassanordnung 7 mit Oeffnungen 9 für frisches Arbeitsgas R. Bezüglich Ausströmrichtung stromaufwärts, bildet eine Anodenplatte 27c mit einer elektrisch isolierenden Wandungspartie 8 die Druckverteilkammer 13, wobei das frische Arbeitsgas R durch einen Leitungsanschluss 15a mit Zentrumseinmündung 16 durch die Anodenplatte 27c in die Druckverteilkammer 13 eingeführt wird.

Auf im wesentlichen senkrecht zur Rezipientenachse A ausgelegten Ebenen sind mehrere Gutträger bzw. Substratträgergitter 3a angeordnet. Auf der anderen Seite, bezüglich der Einlassanordnung 7, wird der Reaktionsraum V durch eine Blendenplatte 24 abgeschlossen, mit Austrittsblenden 21c für die schematisch eingetragenen Bogenentladungen B.

Anschliessend an die Blendenplatte 24 ist die Heisskathodenkammer 23c vorgesehen, worin beispielsweise, an der Peripherie, eine mit Heizstrom I_{H} direkt beheizte Heisskathodenwendel 25c umläuft. Es ist, wie hier nicht mehr dargestellt, ein Niederspannungsgenerator zwischen Anodenplatte 27c und Heisskathode 25c geschaltet. Im Bereiche der Heisskathode 25c münden Spülgasleitungen 33c ein, womit ein Spülgas, wie Argon, in den Heisskathodenbereich eingelassen wird.

Durch das in den Bereich der Heisskathode 25c eingelassene Gas wird die Kathode vor Behandlungsprozesseinwirkungen geschützt. Dies ergibt eine wesentlich längere Standzeit der Heisskathode.

Im dargestellten Ausführungsbeispiel ist die Heisskathode 25c von einer koaxialen Blende 40 umgeben, mit radial gerichteten Oeffnungen 42. Dadurch wird eine Druckabstufung zum Zentrum hin möglich.

Stirnseitig ist die Kathodenkammer 23c durch einen Deckelteil 44 abgeschlossen, mit zentraler Absaugleitung 19c. Die Blendenplatte 24 ist gekühlt (nicht dargestellt), kann aber auch aus einem hochtemperaturbeständigen Material, wie aus Tantal oder einer hochtemperaturbeständigen Keramik, gefertigt sein. Aus ebensolchen Material ist bevorzugterweise auch der Blendenschirm 40 gefertigt.

Gegebenenfalls kann die Platte 7 direkt als Anode beschaltet werden, nämlich dann, wenn der Prozess es zulässt, die Platte 7 aus Metall zu fertigen.

Wie erwähnt wurde, wird durch die Einlassöffnungen 9, vorzugsweise gleichförmig verteilt, Arbeitsgas R in den Reaktionsraum V eingelassen. Die Bogenentladung wird aus den z.B. gleich verteilten Blendenöffnungen 21c sowie, über die Oeffnungen 9 der Anordnung 7, die Anode 27c unterhalten. Gleichzeitig strömen gasförmige Reaktionsprodukte durch die Blendenöffnungen 21c, im Gegenstrom zum Elektronenstrom der Bogenentladung, und durch den Zentralbereich der Kathodenkammer 23c aus der Absaugleitung 29c.

Die Werkstücke werden auf z.B. potentialfrei betriebenen Substratträgergittern 3a abgelegt oder, zur Temperatursteuerung bzw. -regelung über einen Stromzweig, wie anhand von Fig. 1a erläutert wurde, mit einen Bezugspotential oder einer Steuerspannungsquelle verbunden.

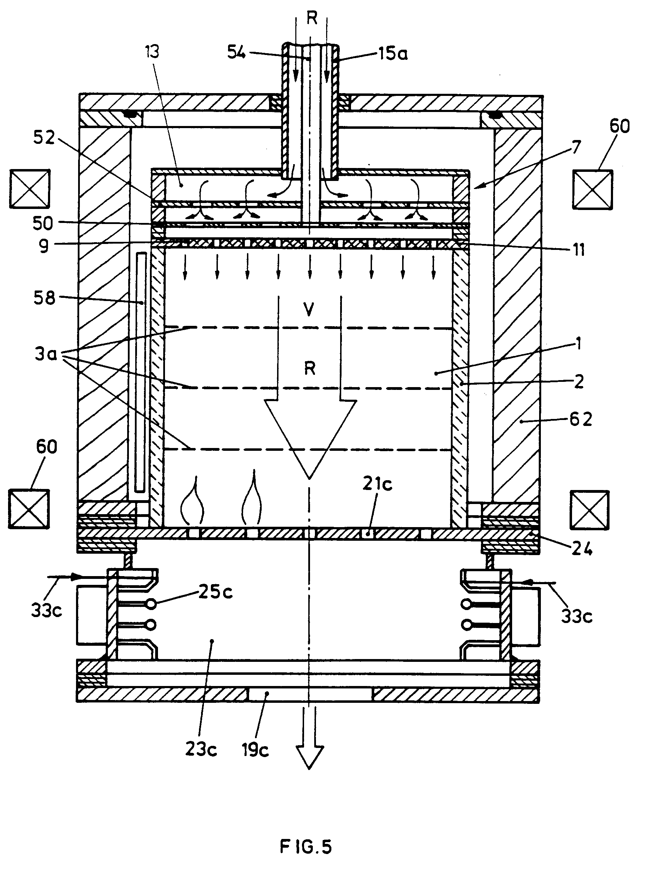

Fig. 5 ist eine derzeit bevorzugte Ausführungsvariante einer erfindungsgemässen Behandlungskammer detaillierter dargestellt. Es werden bei deren Beschreibung die bereits vormals verwendeten Bezugszeichen eingesetzt für bereits beschriebene Teile bzw. Aggregate.

Der eigentliche Rezipient 1 mit Wandung 2 wird von der Einlassanordnung 7 einseitig abgeschlossen. Hinter der Einlassplatte 11 mit Einlassöffnungen 9 für das Arbeitsgas, welche Platte hier auch aus Quarz gefertigt ist, ist eine relativ grossdurchmessrig gelochte, gekühlte Anodenplatte 50 angeordnet, bezuglich der Platte 11 beabstandet und isoliert. Wiederum von der Anodenlochplatte 50 abgesetzt, ist eine weitere Lochplatte 52 zur besseren Gasverteilung angeordnet. Im zentralen Arbeitsgaszuführungsrohr 15a ist, zentral, die elektrische Zuführung 54 für die Anode vorgesehen.

Die Druckverteilkammer wird hier durch zwei Druckstufen zwischen den beiden Verteilplatten 52 und 11 gebildet. Die Anodenplatte 50 ist für das Arbeitsgas möglichst wenig störend, "transparent" ausgebildet, um einerseits dessen Strömung nicht zu stören und um anderseits möglichst wenig durch dieses Gas beeinträchtigt zu werden.

Durch diese Anordnung wird eine optimal homogene Gasverteilung an den hier gleich ausgebildeten Gaseinlässen 9 erreicht und gleichzeitig eine Kühlung der Anode 50 gewährleistet.

Gegebenenfalls können Heizstäbe 58 ausserhalb des Rezipienten 1 vorgesehen sein oder, je nach Leistungsbedarf, auch gekühlte Abschirmbleche.

Im weiteren können gegebenenfalls Magnetspulen 60 ausserhalb des Rezipienten und koaxial zur Anoden/Kathodenstrecke vorgesehen sein, um mittels magnetischer Gleich- oder Wechselfelder die Plasmaverteilung im Reaktionsraum V mit den Gutträgern 3a zu optimieren.

Der eigentliche Rezipient mit gegebenenfalls vorgesehenen Heizungen 58 ist durch eine Aussenwandung 62 abgeschlossen.

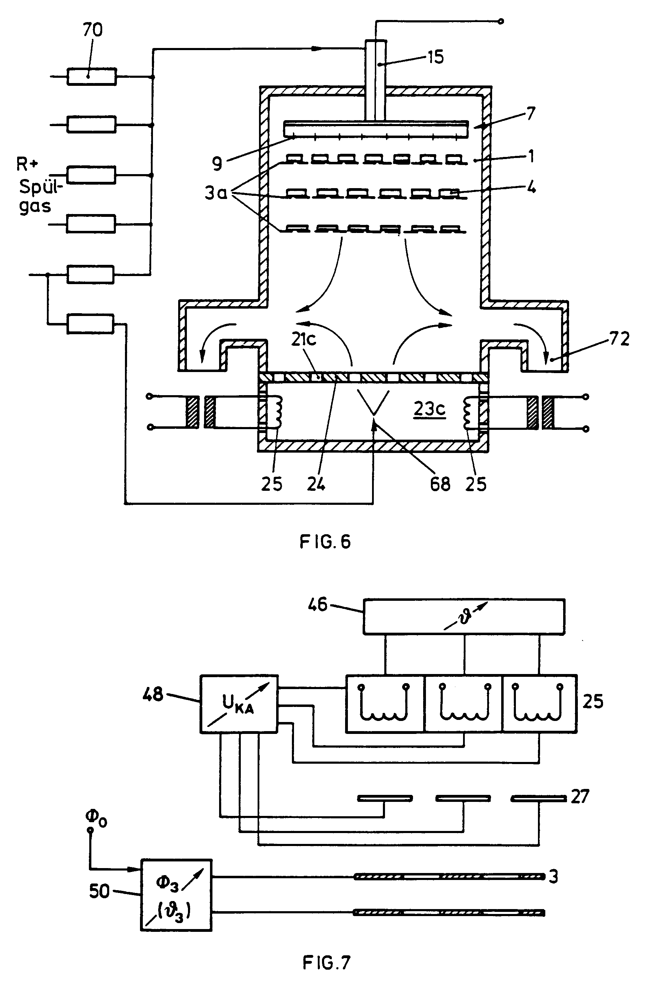

In Fig. 6 ist schematisch eine erfindungsgemässe Behandlungskammer dargestellt, bei der die Absaugung sowohl von Spülgas, eingelassen durch den schematisch dargestellten Einlass 68, wie auch des Arbeitsgases, eingelassen, wie beschrieben wurde, durch die Zuführung 15, peripher erfolgt. Es sind die bereits verwendeten Bezugszeichen eingesetzt, womit die hier dargestellte Anordnung den Fachmann ohne weiteres verständlich wird.

Durch entsprechende Gestaltung der Oeffnungen in der Blenden- und Verteilplatte 24 wird in der Ionisationskammer bzw. Kathodenkammer ein höherer Druck als im Behandlungsraum eingestellt. Dadurch wird eine besonders effektive Ionisierung des Gases erzielt. Dadurch, dass das Gas in der Ionisationskammer 23 im wesentlichen ein Edelgas ist, wird die Lebensdauer der Kathode wesentlich erhöht.

Mit 4 sind, schematisch, auf den Gutträgern 3a angeordnete, zu behandelnde Güter dargestellt, und 70 bezeichnet Durchflussregler, einerseits für das über Anschluss 15 zugeführte Arbeitsgas, anderseits für das über die Zuführung 68 zugeführte Spülgas.

Die Absaugung erfolgt an den Absauganschlüssen 72.

Folgende Dimensionierungen, als relativ kritische Grössen, haben sich bis anhin bewährt:
- Verteilungsdichte D₂₁ der Oeffnungen 21c in der Blendenplatte 24: D₂₁ ≧ 10/m²; vorzugsweise D₂₁ ≧ 50/m²;
- Durchmesser Φ₂₁ der Oeffnungen 21c in der Blendenplatte 24: 1mm ≦ Φ₂₁ ≦ 8mm;
- Dichte D₉ der Oeffnungen 9 in der Platte 7: D₉ ≧ 500/m², vorzugsweise D₉ ≧ 2000/m²,
- Durchmesser Φ₉ der Oeffnungen 9 in der Verteilplatte 7: 0,5mm ≦ Φ₉ ≦ 10mm.

In Fig. 7 sind, schematisch, die elektrisch betriebenen Anlageteile der erfindungsgemässen Anordnung dargestellt. Diese umfassen eine, oder wie dargestellt, mehrere Heisskathoden 25, eine oder mehrere Anoden 27, ein oder mehrere Gutträger 3 für zu behandelndes Gut.

Ein oder mehrere folgender Grössen können zur Optimierung des Behandlungsverfahrens eingestellt werden:
- Sofern mehrere Heisskathoden 25 vorgesehen sind, kann deren Betriebstemperatur, wie bei direkt beheizten Heisskathoden deren Heizstrom, z.B. selektiv eingestellt werden zur Optimierung der Bogenentladungsverteilung. Dies durch eine Betriebstemperatursteuereinheit 46.
- Bei Vorsehen mehrerer Anoden 27 und mehrerer Heisskathoden 25 und analog bei Vorsehen einer Heisskathode und mehrerer Anoden bzw. einer Anode und mehrerer Heisskathoden werden die jeweiligen Niederspannungswerte der Anoden/Kathodenspannungen U_{KA}, an einer Steuereinheit 48, zur Optimierung der Bogenentladungsverteilung z.B. selektiv eingestellt.
- Die elektrischen Betriebspotentiale der, in diesem Falle, mindestens abschnittsweise aus einem leitenden Material bestehenden Gutträger 3 werden an einer selektiven Einstelleinheit 50, sei dies mittels Spannungsquellen 39 gemäss Fig. 1a und/oder Verstellung des Widerstandswertes in einem Stromzweig 35 gemäss genannter Figur, mindestens beeinflusst, insbesondere zur Feineinstellung der Gutträgertemperatur bzw. des Elektronenbeschusses der aufwachsenden Schicht.

Die dargestellten Behandlungsanlagen für reaktive, niederspannungsbogenplasma-unterstützte Verfahren arbeiten mit tiefen Anoden/Kathodenspannungen, beispielsweise unterhalb 150V, können mit hohen Entladungsströmen pro Gutträgerfläche betrieben werden, beispielsweise über 4000 A/m², und ergeben tiefe Behandlungstemperaturen, im wesentlichen unterhalb 900°C. Die hohen ausgenützten Plasmadichten bei tiefen Behandlungstemperaturen ergeben eine Vielzahl von Anwendungen.

Obwohl sich das vorgestellte Verfahren bzw. die Anlage hierfür grundsätzlich für reaktive bogenplasmaunterstützte Behandlungsverfahren eignen, eignen sie sich insbesondere für derartige Beschichtungsverfahren.

## Patentansprüche

1. Verfahren zur gleichspannungs-bogenentladungs-unterstützten, reaktiven Behandlung von mindestens Teilen der Oberfläche eines Gutes, bei dem ein mindestens teilweise zu reagierendes Gas bzw. Gasgemisch, im weiteren Arbeitsgas genannt, in einen evakuierten Rezipienten mit dem Gut eingelassen und gasförmige Reaktionsprodukte aus dem Rezipienten abgesaugt werden und unter Einkoppelung eines Stromes geladener Teilchen in den Rezipienten darin eine Gleichspannungs-Bogenentladung unterhalten wird, dadurch gekennzeichnet, dass die Behandlungswirkungsverteilung mindestens entlang einer vorgegebenen Fläche im Reaktionsraum durch Vorgabe einer flächigen Verteilung des Arbeitsgaseinlasses und/oder durch Vorgabe einer mindestens zweidimensionalen Verteilung von Bogenentladungen im Rezipienten mindestens teilweise festgelegt wird.

2. Verfahren nach Anspruch 1, dadurch gekennzeichnet, dass die eingekoppelten geladenen Teilchen durch Thermoelektronenemission erzeugt werden.

3. Verfahren nach einem der Ansprüche 1 oder 2, dadurch gekennzeichnet, dass eine thermisch Elektronen emittierende Anordnung auch als Elektrode für die Entladung im Rezipienten eingesetzt wird, vorzugsweise als Kathode hierfür.

4. Verfahren nach einem der Ansprüche 1 bis 3, dadurch gekennzeichnet, dass die vorgegebene Fläche aequidistant zur flächigen Verteilung des Arbeitsgaseinlasses gewählt wird und letztere eine im wesentlichen homogene Verteilung ist.

5. Verfahren nach einem der Ansprüche 1 bis 4, dadurch gekennzeichnet, dass die flächige Verteilung des Arbeitsgaseinlasses eine ebene Verteilung ist.

6. Verfahren nach einem der Ansprüche 1 bis 5, dadurch gekennzeichnet, dass die Verteilung des Arbeitsgaseinlasses mittels einer Vielzahl von Einlassöffnungen mit Zuleitungsabschnitten vorgenommen wird und durch selektive Auslegung ihrer Querschnittsflächen und/oder Leitungsabschnittslängen und/oder ihres Beaufschlagungsdruckes und/oder ihrer Ausmündungsrichtung die Verteilung des Arbeitsgaseinlasses festgelegt wird.

7. Verfahren nach einem der Ansprüche 1 bis 6, dadurch gekennzeichnet, dass Einlass und Absaugung so angeordnet sind, dass eine im Nichtbetrieb des Behandlungsverfahrens dazwischen erzwungene Gasströmung über einen wesentlichen Abschnitt des Rezipientinnenvolumens im wesentlichen parallel und vorzugsweise homogen ist.

8. Verfahren nach einem der Ansprüche 1 bis 7, dadurch gekennzeichnet, dass das Gut auf mindestens zwei versetzten Flächen im Rezipienten angeordnet wird.

9. Verfahren nach einem der Ansprüche 1 bis 8, dadurch gekennzeichnet, dass die Bogenentladungen mittels Einkoppeln des Stromes geladener Teilchen durch mehrere Oeffnungen in den Rezipienten und mindestens eine ihnen gegenüberliegende Elektrode erzeugt wird.

10. Verfahren nach einem der Ansprüche 2 bis 9, dadurch gekennzeichnet, dass durch Erzeugung einer Gasströmung im Bereich einer Thermoelektronen emittierenden Anordnung deren Beeinträchtigung durch den Behandlungsprozess mindestens wesentlich reduziert wird.

11. Verfahren nach einem der Ansprüche 1 bis 10, dadurch gekennzeichnet, dass die Richtung einer Anoden-Kathodenstrecke für die Entladung parallel zu einer im wesentlichen durch Einlass und Absaugung festgelegten Richtung für das Arbeitsgas gewählt wird.

12. Verfahren nach einem der Ansprüche 1 bis 11, dadurch gekennzeichnet, dass die Absaugung flächig verteilt vorgenommen wird.

13. Verfahren nach einem der Ansprüche 1 bis 12, dadurch gekennzeichnet, dass eine Anordnung zur flächigen Verteilung der Arbeitsgasein- und/oder -ausströmung bezüglich des Rezipienten als Elektrode für die Bogenentladung eingesetzt wird.

14. Verfahren nach einem der Ansprüche 1 bis 13, dadurch gekennzeichnet, dass mindestens eine der Elektroden für die Bogenentladung durch eine Verteilungsanordnung für den Arbeitsgaseinlass oder die Absaugung vom Innenraum des Rezipienten getrennt wird.

15. Verfahren nach einem der Ansprüche 1 bis 14, dadurch gekennzeichnet, dass das Gut im Rezipienten nicht potentialgebunden angeordnet wird.

16. Verfahren nach einem der Ansprüche 1 bis 15, dadurch gekennzeichnet, dass das Gut über Widerstandsmittel mit einem vorgegebenen elektrischen Potential verbunden wird.

17. Verfahren nach Anspruch 15 oder 16, dadurch gekennzeichnet, dass durch Veränderung über das Gut abfliessenden Stromes dessen Temperatur gesteuert bzw. in einem Temperaturregelkreis gestellt wird bzw. der auf das Gut auftreffende Strom von Ladungsträgern, insbesondere von Elektronen.

18. Verfahren nach einem der Ansprüche 1 bis 17, dadurch gekennzeichnet, dass das elektrische Potential des Gutes zwischen Anoden- und Kathodenpotential festgelegt wird, vorzugsweise zur Einstellung der Guttemperatur eingestellt wird und/oder zur Einstellung des auf das Gut auftreffenden Stromes von Ladungsträgern, insbesondere von Elektronen.

19. Vakuumbehandlungsanlage mit einem Vakuumrezipienten, einer darin einmündenden Einlassanordnung für ein mindestens teilweise im Rezipienten zur Reaktion gebrachtes Arbeitsgas, einer Absauganordnung für gasförmige Reaktionsprodukte, einer Oeffnungsanordnung zum Einkoppeln eines Stromes geladener Teilchen in den Rezipienten, einer Elektrodenanordnung zur Erzeugung einer Gleichspannungs-Bogenentladung im Rezipienten, dadurch gekennzeichnet, dass die Einlassanordnung (7) für das Arbeitsgas eine Vielzahl flächig verteilter Einlassöffnungen (9) umfasst und/oder die Oeffnungsanordnung für den Teilchenstrom mehrere Verteilöffnungen (21a, 21c) zum Rezipienteninnenraum (V) umfasst zur Erzeugung einer mindestens zweidimensional verteilten Bogenentladung.

20. Anlage nach Anspruch 19, dadurch gekennzeichnet, dass, vom Rezipienteninnenraum (V) über die Oeffnungsanordnung (21, 21a, 21c) getrennt, eine thermisch Elektronen emittierende Anordnung (25, 25c) zur Erzeugung des Teilchenstromes vorgesehen ist.

21. Anlage nach Anspruch 20, dadurch gekennzeichnet, dass die Elektronen emittierende Anordnung eine direkt oder indirekt beheizte Heisskathode ist.

22. Anlage nach Anspruch 21, dadurch gekennzeichnet, dass die Heisskathode Elektrode, vorzugsweise Kathode, der Elektrodenanordnung ist.

23. Anlage nach einem der Ansprüche 20 bis 22, dadurch gekennzeichnet, dass die emittierende Anordnung in einer Kammer (23, 23c) angeordnet ist, in welche eine Gaszuführanordnung (33, 33c) einmündet.

24. Anlage nach einem der Ansprüche 19 bis 23, dadurch gekennzeichnet, dass die Einlassanordnung (7, 41) und die Absauganordnung (19, 19c, 72) einerseits die Elektroden (25c, 27c, 50) für die Bogenentladung bilden, anderseits so angeordnet sind, dass im Betrieb eine Gasströmung zwischen Einlassanordnung und Absauganordnung und die Anoden/Kathodenstrecke im wesentlichen parallel sind.

25. Anlage nach einem der Ansprüche 19 bis 24, dadurch gekennzeichnet, dass die Einlassanordnung (7) oder die Absaugung eine Lochplatte (11) umfasst, die gleichzeitig eine der Elektroden ist.

26. Anlage nach einem der Ansprüche 19 bis 25, dadurch gekennzeichnet, dass die Einlassanordnung (7) oder die Absaugung eine Lochplatte (11) umfasst, einseitig eine Kammer (13) abschliessend, und dass eine der Elektroden (50) für die Entladung darin oder daran (13) angeordnet ist.

27. Anlage nach einem der Ansprüche 19 bis 26, dadurch gekennzeichnet, dass die Oeffnungsanordnung für den Teilchenstrom eine Lochplatte (24) umfasst.

28. Anlage nach Anspruch 22, dadurch gekennzeichnet, dass die Lochplatte (24) mindestens Teil der Einlass- oder Absauganordnung ist, womit im Betrieb durch die Lochplatte sowohl der Teilchenstrom wie auch Gas fliesst.

29. Anlage nach einem der Ansprüche 19 bis 28, dadurch gekennzeichnet, dass die Anlage axial symmetrisch, vorzugsweise zylindrisch aufgebaut ist mit Einlassanordnung und Absauganordnung stirnseitig und ebenso angeordneter Elektrodenanordnung für die Entladung.

30. Anlage nach einem der Ansprüche 19 bis 29, dadurch gekennzeichnet, dass mindestens eine bezüglich potentialgebundener Anlageteile isolierte Halterung für Behandlungsgut vorgesehen ist.

31. Anlage nach einem der Ansprüche 19 bis 29, dadurch gekennzeichnet, dass mindestens eine über ein Widerstandselement auf ein elektrisches Poential gelegte Halterung für Behandlungsgut vorgesehen ist.

32. Anlage nach Anspruch 31, dadurch gekennzeichnet, dass das Widerstandselement einstellbar ist.

33. Anlage nach Anspruch 32, dadurch gekennzeichnet, dass das Widerstandselement ein Stellglied in einem Temperaturregelkreis für das Gut oder in einer Temperatursteuerung für die Guttemperatur ist oder für den auf das Gut auftreffenden Elektronenstrom.

34. Anlage nach einem der Ansprüche 19 bis 29, 31 bis 33, dadurch gekennzeichnet, dass mindestens eine Guthalterung vorgesehen ist, die über eine steuerbare Spannungsquelle auf ein Bezugspotential gelegt ist.

35. Anlage nach Anspruch 34, dadurch gekennzeichnet, dass die Spannungsquelle ein Stellglied für die Guttemperatur zu deren Steuerung oder Regelung bildet.

## Claims

1. A method of dc voltage-arc discharge-assisted reactive treatment of at least parts of the surface of an object, wherein a gas or gas mixture which is to be at least partially reacted, hereinafter referred to as working gas, is let into an evacuated container with the object and gaseous reaction products are sucked out of the container and, with coupling of a stream of charged particles into the container, a dc voltage arc discharge is maintained therein, characterised in that the distribution of treatment action at least along a predetermined surface in the reaction space is at least partially fixed by predetermining a distribution in respect of area of the working gas inlet and/or by predetermining an at least two-dimensional distribution of arc discharges in the container.

2. A method according to claim 1 characterised in that the charged particles which are coupled into the container are produced by thermionic electron emission.

3. A method according to one of claims 1 and 2 characterised in that an arrangement thermionically emitting electrons is also used as an electrode for the discharge in the container, preferably as a cathode therefor.

4. A method according to one of claims 1 to 3 characterised in that the predetermined surface is selected to be equidistant in relation to the distribution in respect of area of the working gas inlet and the latter distribution is a substantially homogeneous distribution.

5. A method according to one of claims 1 to 4 characterised in that the distribution in respect of area of the working gas inlet is a planar distribution.

6. A method according to one of claims 1 to 5 characterised in that the distribution of the working gas inlet is effected by means of a plurality of inlet openings with feed conduit portions and selective design of the cross-sectional areas thereof and/or conduit portion lengths and/or the pressure acting upon sane and/or their discharge direction provides for determining the distribution of the working gas inlet.

7. A method according to one of claims 1 to 6 characterised in that inlet and suction removal means are so arranged that a gas flow enforced therebetween in the condition of non-operation of the treatment method is substantially parallel and preferably homogeneous over a substantial portion of the internal volume of the container.

8. A method according to one of claims 1 to 7 characterised in that the object is arranged on at least two displaced surfaces in the container.

9. A method according to one of claims 1 to 8 characterised in that the arc discharges are produced by means of coupling of the stream of charged particles through a plurality of openings into the container and at least one electrode which is disposed opposite to said openings.

10. A method according to one of claims 2 to 9 characterised in that by the production of a gas flow in the region of an arrangement emitting thermionic electrons, the adverse effect thereon by the treatment process is at least substantially reduced.

11. A method according to one of claims 1 to 10 characterised in that the direction of an anode-cathode path for the discharge is selected to be parallel to a direction for the working gas, which is substantially determined by the inlet and the suction removal means.

12. A method according to one of claims 1 to 11 characterised in that suction removal is effected in such a manner as to be distributed over an area.

13. A method according to one of claims 1 to 12 characterised in that an arrangement for distribution in respect of area of the working gas inlet flow and/or discharge flow relative to the container is used as an electrode for the arc discharge.

14. A method according to one of claims 1 to 13 characterised in that at least one of the electrodes for the arc discharge is separated from the internal space of the container by a distribution arrangement for the working gas inlet or the suction removal.

15. A method according to one of claims 1 to 14 characterised in that the object is arranged in the container in such a way as not to be potential-bound.

16. A method according to one of claims 1 to 15 characterised in that the object is connected by way of resistance means to a predetermined electrical potential.

17. A method according to claim 15 or claim 16 characterised in that by a variation in the current flowing away by way of the object its temperature is controlled or is set in a temperature regulating circuit or the stream, which impinges on the material, of charge carriers, in particular electrons, is controlled.

18. A method according to one of claims 1 to 17 characterised in that the electrical potential of the object is fixed between anode and cathode potential, and is preferably set for adjusting the temperature of the object and/or for adjusting the stream, which impinges on the object, of charge carriers, in particular electrons.

19. A vacuum treatment installation having a vacuum container, an inlet arrangement which opens into same for a working gas which is at least partially caused to react in the container, a suction removal arrangement for gaseous reaction products, an opening arrangement for coupling a stream of charged particles into the container, and an electrode arrangement for producing a dc voltage arc discharge in the container characterised in that the inlet arrangement (7) for the working gas includes a plurality of inlet openings (9) which are distributed in respect of area and/or the opening arrangement for the stream of particles includes a plurality of distribution openings (21a, 21c) towards the internal space (V) of the container for producing an at least two-dimensionally distributed arc discharge.

20. An installation according to claim 19 characterised in that, separated from the internal space (V) of the container by way of the opening arrangement (21, 21a, 21c), an arrangement (25, 25c) for thermionically emitting electrons is provided for producing the stream of particles.

21. An installation according to claim 20 characterised in that the electron-emitting arrangement is a directly or indirectly heated hot cathode.

22. An installation according to claim 21 characterised in that the hot cathode is an electrode, preferably the cathode, of the electrode arrangement.

23. An installation according to one of claims 20 to 22 characterised in that the emitting arrangement is disposed in a chamber (23, 23c) into which a gas feed arrangement (33, 33c) opens.

24. An installation according to one of claims 19 to 23 characterised in that the inlet arrangement (7, 41) and the suction removal arrangement (19, 19c, 72) on the one hand form the electrodes (25c, 27c, 50) for the arc discharge and on the other hand are so arranged that in operation a gas flow between the inlet arrangement and the suction removal arrangement and the anode/cathode path are substantially parallel.

25. An installation according to one of claims 19 to 24 characterised in that the inlet arrangement (7) or the suction removal means includes an apertured plate (11) which at the same time is one of the electrodes.

26. An installation according to one of claims 19 to 25 characterised in that the inlet arrangement ( 7) or the suction removal means includes an apertured plate (11), closing off a chamber (13) at one side, and that one of the electrodes (50) is arranged for the discharge therein or thereat (13).

27. An installation according to one of claims 19 to 26 characterised in that the opening arrangement for the particle stream includes an apertured plate (24).

28. An installation according to claim 22 characterised in that the apertured plate (24) is at least part of the inlet or suction removal arrangement, whereby in operation both the particle stream and also gas flows through the apertured plate.

29. An installation according to one of claims 19 to 28 characterised in that the installation is of an axially symmetrical and preferably cylindrical configuration with inlet arrangement and suction removal arrangement at the ends and likewise arranged electrode arrangement for the discharge.

30. An installation according to one of claims 19 to 29 characterised in that there is provided at least one holder for the object to be treated, which holder is insulated with respect to potential-bound parts of the installation.

31. An installation according to one of claims 19 to 29 characterised in that there is provided at least one holder for the object to be treated, which holder is put to an electrical potential by way of a resistance element.

32. An installation according to claim 31 characterised in that the resistance element is adjustable.

33. An installation according to claim 32 characterised in that the resistance element is a control member in a temperature regulating circuit for the object or in a temperature control means for the object temperature or for the electron stream impinging on the object.

34. An installation according to one of claims 19 to 29 and 31 to 33 characterised in that there is provided at least one object holder which is put to a reference potential by way of a controllable voltage source.

35. An installation according to claim 34 characterised in that the voltage source forms a control member for the object temperature for controlling or regulating same.

## Revendications

1. Procédé pour le traitement réactif à l'aide d'une décharge en arc à tension continue de parties au moins de la surface d'un produit, selon lequel un gaz ou un mélange de gaz à faire réagir au moins en partie, appelé dans ce qui suit gaz de travail, est introduit dans un récipient sous vide contenant le produit, des produits de réaction gazeux sont aspirés du récipient, et une décharge en arc à tension continue est entretenue dans le récipient moyennant l'injection dans celui-ci d'un courant de particules chargées, caractérisé en ce que la répartition d'action de traitement est au moins en partie déterminée au moins le long d'une surface prédéfinie, dans l'espace de réaction, par la définition préalable d'une répartition plane de l'admission du gaz de travail et/ou par la définition préalable d'une répartition à au moins deux dimensions de décharges en arc dans le récipient.

2. Procédé selon la revendication 1, caractérisé en ce que les particules chargées injectées sont produites par émission d'électrons par voie thermique.

3. Procédé selon l'une des revendications 1 ou 2, caractérisé en ce qu'un dispositif émettant des électrons par voie thermique est également utilisé comme électrode pour la décharge dans le récipient, et de préférence comme cathode.

4. Procédé selon l'une des revendications 1 à 3, caractérisé en ce que la surface prédéfinie est choisie pour être équidistante de la répartition plane de l'admission du gaz de travail, et cette répartition est essentiellement homogène.

5. Procédé selon l'une des revendications 1 à 4, caractérisé en ce que la répartition plane de l'admission du gaz de travail est une répartition égale.

6. Procédé selon l'une des revendications 1 à 5, caractérisé en ce que la répartition de l'admission du gaz de travail est réalisée à l'aide d'une multiplicité d'orifices d'admission comportant des sections d'amenée, et la répartition de l'admission du gaz de travail est déterminée par une étude sélective de leurs surfaces de section transversale et/ou des longueurs de section de conduite et/ou de leur pression de contrainte et/ou de leur sens de sortie.

7. Procédé selon l'une des revendications 1 à 6, caractérisé en ce que l'admission et l'aspiration sont disposées de telle sorte qu'un courant de gaz forcé lors de l'arrêt du procédé de traitement est sensiblement parallèle et de préférence homogène sur une section importante du volume intérieur du récipient.

8. Procédé selon l'une des revendications 1 à 7, caractérisé en ce que le produit est disposé dans le récipient sur au moins deux surfaces décalées.

9. Procédé selon l'une des revendications 1 à 8, caractérisé en ce que les décharges en arc sont produites à l'aide de l'injection dans le récipient, par plusieurs orifices, du courant de particules chargées, et à l'aide d'une électrode située en face de ces ouvertures.

10. Procédé selon l'une des revendications 2 à 9, caractérisé en ce que grâce à la production d'un courant de gaz dans la zone d'un dispositif émettant des électrons émis par voie thermique, la dégradation de celui-ci par le processus de traitement est au moins sensiblement réduite.

11. Procédé selon l'une des revendications 1 à 10, caractérisé en ce que le sens choisi pour une distance anode/cathode pour la décharge est parallèle à un sens déterminé essentiellement par l'admission et l'aspiration, pour le gaz de travail.

12. Procédé selon l'une des revendications 1 à 11, caractérisé en ce que l'aspiration est réalisée suivant une répartition plane.

13. Procédé selon l'une des revendications 1 à 12, caractérisé en ce qu'un dispositif pour la répartition plane de l'entrée et/ou la sortie du gaz de travail par rapport au récipient est utilisé comme électrode pour la décharge en arc.

14. Procédé selon l'une des revendications 1 à 13, caractérisé en ce que l'une au moins des électrodes prévues pour la décharge en arc est séparée de l'intérieur du récipient par un dispositif de répartition pour l'admission du gaz de travail ou l'aspiration.

15. Procédé selon l'une des revendications 1 à 14, caractérisé en ce que le produit est disposé dans le récipient sans être relié à un potentiel.

16. Procédé selon l'une des revendications 1 à 15, caractérisé en ce que le produit est relié au potentiel électrique prédéfini par l'intermédiaire de moyens formant résistance.

17. Procédé selon la revendication 15 ou 16, caractérisé en ce que grâce à une variation du courant s'écoulant sur le produit, la température de celui-ci est commandée ou réglée dans un circuit régulateur de température, ou le courant de porteurs de charge, en particulier d'électrons, arrivant sur le produit.

18. Procédé selon l'une des revendications 1 à 17, caractérisé en ce que le potentiel électrique du produit est déterminé entre les potentiels d'anode et de cathode et est de préférence réglé en vue du réglage de la température du produit et/ou en vue du réglage du courant de porteurs de charge, en particulier d'électrons, arrivant sur le produit.

19. Installation de traitement sous vide comprenant un récipient sous vide, un dispositif d'admission, débouchant dans celui-ci, pour un gaz de travail amené en réaction au moins partiellement dans le récipient, un dispositif d'aspiration pour les produits de réaction gazeux, un dispositif d'ouverture pour l'injection d'un courant de particules chargées dans le récipient, et un dispositif d'électrodes pour la production d'une décharge en arc a tension continue dans le récipient, caractérisée en ce que le dispositif d'admission (7) prévu pour le gaz de travail comprend une multiplicité d'orifices d'admission (9) répartis de façon plane et/ou le dispositif d'ouverture prévu pour le courant de particules comprend plusieurs orifices de répartition (21a, 21c) dirigés vers l'intérieur (V) du récipient, en vue de la production d'une décharge en arc répartie au moins à deux dimensions.

20. Installation selon la revendication 19, caractérisée en ce qu'il est prévu, séparé de l'intérieur (V) du récipient par l'intermédiaire du dispositif d'ouverture (21, 21a, 21c), un dispositif (25, 25c) émettant des électrons par voie thermique pour la production du courant de particules.

21. Installation selon la revendication 20, caractérisée en ce que le dispositif émettant des électrons est une cathode chaude chauffée directement ou indirectement.

22. Installation selon la revendication 21, caractérisée en ce que la cathode chaude est une électrode, et de préférence la cathode, du dispositif d'électrodes.

23. Installation selon l'une des revendications 20 à 22, caractérisée en ce que le dispositif d'émission est disposé dans la chambre (23, 23c), dans laquelle débouche un dispositif d'amenée de gaz (33, 33c).

24. Installation selon l'une des revendications 19 à 23, caractérisée en ce que le dispositif d'admission (7, 41) et le dispositif d'aspiration (19, 19c, 72) définissent d'une part les électrodes (25c, 27c, 50) pour la décharge en arc, et sont disposés d'autre part pour que, lors du fonctionnement, un courant de gaz entre le dispositif d'admission et le dispositif d'aspiration et la distance anode/cathode soient sensiblement parallèles.

25. Installation selon l'une des revendications 19 à 24, caractérisée en ce que le dispositif d'admission (7) ou l'aspiration comprend une plaque perforée (11) qui définit en même temps l'une des électrodes.

26. Installation selon l'une des revendications 19 à 25, caractérisée en ce que le dispositif d'admission (7) ou l'aspiration comprend une plaque perforée (11) qui ferme unilatéralement une chambre (13), et en ce que l'une des électrodes (50) pour la décharge est disposée dans celle-ci ou contre celle-ci (13).

27. Installation selon l'une des revendications 19 à 26, caractérisée en ce que le dispositif d'ouverture pour le courant de particules comprend une plaque perforée (24).

28. Installation selon la revendication 22, caractérisée en ce que la plaque perforée (24) forme au moins une partie du dispositif d'admission ou d'aspiration, moyennant quoi, pendant le fonctionnement, le courant de particules et le gaz s'écoulent tous les deux à travers la plaque perforée.

29. Installation selon l'une des revendications 19 à 28, caractérisée en ce que l'installation présente une structure symétrique axialement, de préférence cylindrique, le dispositif d'admission et le dispositif d'aspiration étant disposés côté frontal, ainsi que le dispositif d'électrodes pour la décharge.

30. Installation selon l'une des revendications 19 à 29, caractérisée en ce qu'il est prévu, pour le produit à traiter, au moins un support isolé par rapport à des éléments d'installation reliés à un potentiel.

31. Installation selon l'une des revendications 19 à 29, caractérisée en ce qu'il est prévu, pour le produit à traiter, au moins un support mis au potentiel électrique par l'intermédiaire d'un élément de résistance.

32. Installation selon la revendication 31, caractérisée en ce que l'élément de résistance est réglable.

33. Installation selon la revendication 32, caractérisée en ce que l'élément de résistance est un organe de réglage dans un circuit régulateur de température prévu pour le produit ou dans une commande de température prévue pour la température du produit ou pour le courant d'électrons arrivant sur le produit.

34. Installation selon l'une des revendications 19 à 29, 31 à 33, caractérisée en ce qu'il est prévu au moins un support de produit qui est mis à un potentiel de référence par l'intermédiaire d'une source de tension apte à être commandée.

35. Installation selon la revendication 34, caractérisée en ce que la source de tension définit un organe de réglage pour la température du produit, en vue de la commande ou de la régulation de celle-ci.
